# EUROPEAN PATENT APPLICATION

(11) **EP 4 766 105 A1**
(43) Date of publication of application: **24.06.2026**
(21) Application number: 25223792.0
(22) Date of filing: 16.12.2025
(51) Int. Cl.: H10H 20/811, H10H 20/813, H10H 20/824

(54) **NITRIDE SEMICONDUCTOR LIGHT-EMITTING ELEMENT**

(30) Priority: 19.12.2024 JP 2024224249; 12.11.2025 JP 2025191706
(71) Applicant: NICHIA CORPORATION, Tokushima 774-8601 (JP)
(72) Inventor: FUNAKOSHI, Ryota, Anan-shi, Tokushima, 774-8601 (JP)
(74) Representative: Betten & Resch

(57) **Abstract**

A light-emitting element includes: a first semiconductor portion including a first n-side semiconductor layer, a first active layer disposed on the first n-side semiconductor layer and configured to emit ultraviolet light, and a first p-side semiconductor layer disposed on the first active layer; and a second semiconductor portion including a second n-side semiconductor layer disposed on the first semiconductor portion, a second active layer disposed on the second n-side semiconductor layer and configured to emit ultraviolet light, and a second p-side semiconductor layer disposed on the second active layer. The first p-side semiconductor layer includes a first layer containing Al and a second layer disposed on the first layer and containing Al and a p-type impurity. The second p-side semiconductor layer includes a third layer containing Al and a fourth layer disposed on the third layer and containing Al and a p-type impurity.

## Description

### CROSS-REFERENCE TO RELATED APPLICATION

This application is based on and claims priority to Japanese Patent Application No. 2024-224249, filed on December 19, 2024, and Japanese Patent Application No. 2025-191706, file on November 12, 2025. The entire contents of these applications are incorporated herein by reference.

### TECHNICAL FIELD

The present disclosure relates to a nitride semiconductor light-emitting element.

### BACKGROUND

For example, a light-emitting element in which a plurality of semiconductor portions, each of which includes an active layer, are connected in series via a tunnel junction is disclosed in Japanese Patent Publication No. 2019-517144. However, a light-emitting element in which a plurality of semiconductor portions that emit ultraviolet light are joined via a tunnel junction has a disadvantage that the forward voltage increases.

### SUMMARY

An object of certain embodiments of the present disclosure is to provide a nitride semiconductor light-emitting element in which a forward voltage can be reduced in a light-emitting element in which a plurality of semiconductor portions that emit ultraviolet light are joined via a tunnel junction.

A nitride semiconductor light-emitting element according to an embodiment of the present disclosure includes: a first semiconductor portion including a first n-side semiconductor layer, a first active layer disposed on the first n-side semiconductor layer and configured to emit ultraviolet light, and a first p-side semiconductor layer disposed on the first active layer; and a second semiconductor portion including a second n-side semiconductor layer disposed on the first semiconductor portion, a second active layer disposed on the second n-side semiconductor layer and configured to emit ultraviolet light, and a second p-side semiconductor layer disposed on the second active layer. The first p-side semiconductor layer includes a first layer containing Al and a second layer disposed on the first layer and containing Al and a p-type impurity. The second p-side semiconductor layer includes a third layer containing Al and a fourth layer disposed on the third layer and containing Al and a p-type impurity The second n-side semiconductor layer is joined via a tunnel junction to the second layer. A thickness of the first layer is less than a thickness of the third layer.

The nitride semiconductor light-emitting element according to certain embodiments of the present disclosure can provide a nitride semiconductor light-emitting element in which a forward voltage can be reduced in a light-emitting element in which a plurality of semiconductor portions that emit ultraviolet light are joined via a tunnel junction.

### BRIEF DESCRIPTION OF DRAWINGS

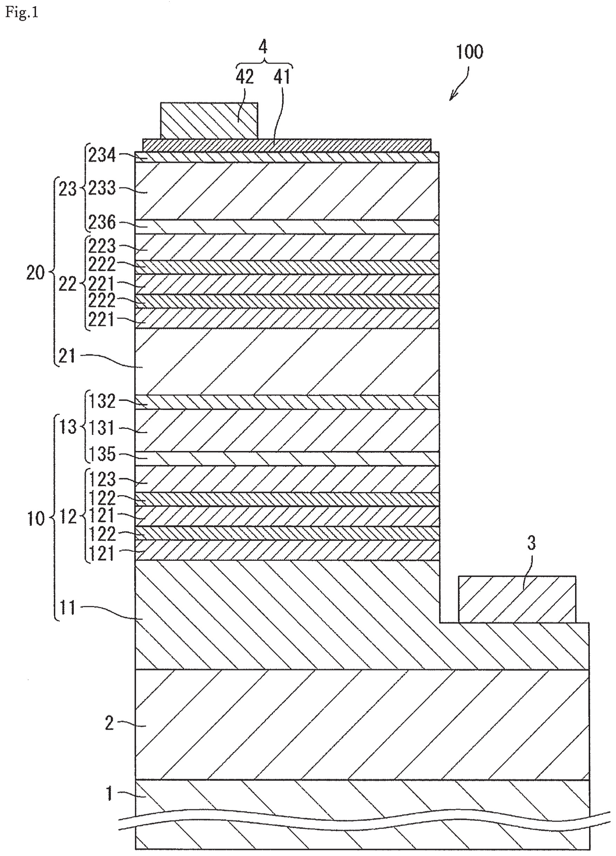

FIG. 1 is a cross-sectional view illustrating a nitride semiconductor light-emitting element according to an embodiment.

### DETAILED DESCRIPTION

Hereinafter, embodiments of the present disclosure are described with reference to the drawings. The described embodiments of a nitride semiconductor light-emitting element are examples illustrating the technical concepts of the present disclosure, but the invention is not limited to the described examples. The sizes, positional relationship, and the like of members illustrated in the drawings may be exaggerated in order to clarify explanation.

The term "on" in the present disclosure encompasses both a configuration in which a member is disposed directly on and in contact with another member and a configuration in which a member is disposed on another member with a space or an intervening member interposed therebetween.

As described above, for example, the forward voltage applied to a light-emitting element in which a plurality of semiconductor portions that emit ultraviolet light are connected via a tunnel junction may increase depending on the composition of the layers to be joined via a tunnel junction.

For example, a GaN layer is generally used as a layer to be joined via a tunnel junction, and as a light-emitting element including a plurality of semiconductor portions that emit blue light or light having a wavelength longer than that of blue light, a light-emitting element having a high light emission output while reducing an increase in forward voltage can be formed by joining an n-type GaN layer and a p-type GaN layer via a tunnel junction. However, in a light-emitting element including a plurality of semiconductor portions that emit ultraviolet light, for example, when a GaN layer is used as a layer joined via a tunnel junction, there is a possibility that ultraviolet light is absorbed in the GaN layer joined via a tunnel junction and light emission output is reduced. As a solution, it is conceivable to use an AlGaN layer instead of the GaN layer as a layer joined via a tunnel junction. However, in a nitride semiconductor layer containing Al such as an AlGaN layer, the activation energy of a p-type impurity such as Mg increases. The activation energy of the p-type impurity in the nitride semiconductor layer containing Al increases as the Al composition ratio increases. That is, in the nitride semiconductor layer containing Al, the activation energy of the p-type impurity increases, and thus the p-type impurity is less likely to be activated, and the hole density decreases, resulting in high resistance. Thus, when the AlGaN layer is used as a layer joined via a tunnel junction, the absorption of ultraviolet light by the layer joined via a tunnel junction is suppressed, but the quantity of holes generated by the tunnel junction is reduced, and the forward voltage is increased.

As a result of intensive studies, the present inventors have found that, even when tunnel-junction layers include a nitride semiconductor layer containing Al, a decrease in the quantity of holes generated by the tunnel junction can be reduced by adjusting the layer configuration and the thickness relationship in the entire nitride semiconductor, and accordingly an increase in the forward voltage of the light-emitting element can be suppressed. The present inventors therefore have developed a nitride semiconductor light-emitting element according to the present disclosure.

First, a nitride semiconductor light-emitting element according to the present disclosure will be described in detail with reference to FIG. 1.

### Embodiment

As illustrated in FIG. 1, a nitride semiconductor light-emitting element 100 according to the embodiment includes, on a substrate 1, a first semiconductor portion 10 and a second semiconductor portion 20 disposed on the first semiconductor portion 10, each of the first semiconductor portion 10 and the second semiconductor portion 20 emitting light of a predetermined wavelength.

The first semiconductor portion 10 includes a first n-side semiconductor layer 11, a first active layer 12 that emits ultraviolet light and is disposed on the first n-side semiconductor layer 11, and a first p-side semiconductor layer 13 disposed on the first active layer 12.

The second semiconductor portion 20 includes a second n-side semiconductor layer 21 disposed on the first semiconductor portion 10, a second active layer 22 that emits ultraviolet light and is disposed on the second n-side semiconductor layer 21, and a second p-side semiconductor layer 23 disposed on the second active layer 22.

The first p-side semiconductor layer 13 includes a first layer 131 containing Al and a second layer 132 containing Al and a p-type impurity and disposed on the first layer 131. The second p-side semiconductor layer 23 includes a third layer 233 containing Al and a fourth layer 234 containing Al and a p-type impurity and disposed on the third layer 233. The second n-side semiconductor layer 21 is joined via a tunnel junction to the second layer 132, and the thickness of the first layer 131 is less than the thickness of the third layer 233.

In the present specification, the term "n-side semiconductor layer" means a semiconductor layer having n-type conductivity. For example, an n-type conductivity refers to an n-side semiconductor layer even if it contains a slight amount of p-type impurity.

Also, in the present specification, the term "p-side semiconductor layer" means a semiconductor layer having the p-type conductivity. For example, a p-type conductivity refers to a p-side semiconductor layer even if it contains a slight amount of n-type impurity.

In the nitride semiconductor light-emitting element 100 according to the embodiment configured as described above, even when both the second layer 132 joined via a tunnel junction to the second n-side semiconductor layer 21 and the first layer 131 located under the second layer 132 are layers containing Al, the increase in the forward voltage can be reduced by the thickness of the first layer 131 being less than the thickness of the third layer 233.

In this manner, the nitride semiconductor light-emitting element 100 can provide a nitride semiconductor light-emitting element that emits ultraviolet light in which the increase in forward voltage is reduced.

In addition, the thickness of the third layer 233 is greater than the thickness of the first layer 131, so that V-pits formed during manufacturing can be appropriately filled when forming the third layer 233. The V-pits are regions where a current is likely to concentrate. If the V-pits are not filled appropriately, an electrostatic breakdown voltage may decrease. In other words, filling the V-pits makes it possible to reduce the decrease in the electrostatic breakdown voltage.

Here, the thickness of the first layer 131 is, for example, in a range of 20 nm to 120 nm, and the thickness of the third layer 233 is, for example, in a range of 130 nm to 180 nm.

Here, the Al composition ratio of the first layer 131 is preferably lower than the Al composition ratio of the third layer 233. This can reduce the band gap of the first layer 131, thereby improving the supply of holes to the first active layer 12.

In addition, the Al composition ratio of the first layer 131 and the Al composition ratio of the third layer 233 can be appropriately set in consideration of the wavelengths of the ultraviolet light emitted by the first active layer 12 and the ultraviolet light emitted by the second active layer 22. The difference between the Al composition ratio of the first layer 131 and the Al composition ratio of the third layer 233 is preferably, for example, 2% or less.

The first active layer 12 may include, for example, a first well layer 122, a first barrier layer 121 and a first barrier layer 123 both containing Al. In this case, the Al composition ratio of the first layer 131 is preferably lower than the Al composition ratio of the first barrier layer 121 and the first barrier layer 123. Because the Al composition ratio of the first layer 131 is lower than the Al composition ratio of the first barrier layer 121 and the Al composition ratio of the first barrier layer 123, a decrease in the holes supplied to the first active layer 12 via the tunnel junction can be reduced. That is, the band gap of the first layer 131 can be reduced, and the decrease in the supply of holes to the first active layer 12 by the first layer 131 can be reduced. The first barrier layer 121 and the first barrier layer 123 are different in thickness and position in the first active layer 12, as described below.

The second active layer 22 may include, for example, a second well layer 222, a second barrier layer 221 containing Al, and a second barrier layer 223 containing Al. In this case, the Al composition ratio of the third layer 233 is preferably lower than the Al composition ratio of the second barrier layer 221 and the Al composition ratio of the second barrier layer 223. The second barrier layer 221 and the second barrier layer 223 are different in thickness and position in the second active layer 22, as described below. When the Al composition ratio of the third layer 233 is lower than the Al composition ratio of the second barrier layer 221 and the Al composition ratio of the second barrier layer 223, the band gap of the third layer 233 does not become too wide, and the holes generated by the fourth layer 234 are easily supplied to the second active layer 22.

The first p-side semiconductor layer 13 may include a fifth layer 135 containing Al between the first layer 131 and the first active layer 12. The second p-side semiconductor layer 23 may include a sixth layer 236 containing Al between the third layer 233 and the second active layer 22. The fifth layer 135 has the function of blocking the outflow of electrons supplied from the first n-side semiconductor layer 11 to the first active layer 12. On the other hand, the fifth layer 135 is a layer that controls the supply of holes generated by the tunnel junction to the first active layer 12. The quantity of holes to be generated in the tunnel junction is smaller than the quantity of holes to be generated in the p-side semiconductor layer, for example. Thus, the thickness of the fifth layer 135 is less than the thickness of the sixth layer 236, so that even if a relatively small quantity of holes are generated in the tunnel junction, a certain quantity of holes can be easily supplied to the first active layer 12. Holes are supplied from the second p-side semiconductor layer 23 to the second active layer 22. Thus, even when the sixth layer 236 is thicker than the fifth layer 135, a sufficient quantity of holes are likely to be supplied to the second active layer 22. In addition, the sixth layer 236 is thicker than the fifth layer 135, so that it is possible to effectively block the outflow of electrons supplied from the tunnel junction to the second active layer 22.

In addition, as described above, the fifth layer 135 containing Al is a layer having the function of blocking electrons, and in order to have the function of blocking electrons, for example, the Al composition ratio of the fifth layer 135 is preferably higher than the Al composition ratio of the barrier layer in each of the first active layer 12 and the second active layer 22.

The first p-side semiconductor layer 13 includes the fifth layer 135 containing Al between the first layer 131 and the first active layer 12. The second p-side semiconductor layer 23 includes the sixth layer 236 containing Al between the third layer 233 and the second active layer 22. The Al composition ratio of the fifth layer 135 is set to be lower than the Al composition ratio of the sixth layer 236, so that a certain quantity of electrons can be easily supplied to the second active layer 22. Setting the Al composition ratio of the sixth layer 236 to be higher than the Al composition ratio of the fifth layer 135 makes it possible to effectively block the outflow of electrons.

The thickness of the first layer 131 can be greater than the thickness of the fifth layer 135, and thus, the V-pits formed in the manufacturing process may be filled adequately, allowing the electrostatic breakdown voltage to improve.

The fifth layer 135 and the sixth layer 236 are doped with a p-type impurity, and the p-type impurity concentration in the fifth layer 135 is preferably higher than the p-type impurity concentration in the sixth layer 236. Accordingly, holes can be effectively supplied to the first active layer 12 by the fifth layer 135, and the p-type impurity concentration in the sixth layer 236 can be reduced, allowing crystallinity to improve.

As illustrated in FIG. 1, the above-described layers are provided on a substrate 1 with a foundation layer 2 interposed therebetween.

An n-side electrode 3 is provided to be connected to the first n-side semiconductor layer 11, and a p-side electrode 4 is provided on the second p-side semiconductor layer 23. Hereinafter, each component in the nitride semiconductor light-emitting element 100 according to the present disclosure will be described in detail.

### Substrate 1

For example, an insulating substrate of sapphire, spinel (MgAl₂O₄), or the like taking any of a C plane, an R plane, and an A plane as a primary surface may be used as the substrate 1. As the substrate 1, SiC (including 6H, 4H, and 3C), ZnS, ZnO, GaAs, Si, or the like may be used. The substrate 1 may be removed after the semiconductor layered body including the first semiconductor portion 10 and the second semiconductor portion 20 is formed, and thus eventually the nitride semiconductor light-emitting element 100 may not include the substrate 1.

### Foundation Layer 2

The foundation layer 2 is disposed between the substrate 1 and the first n-side semiconductor layer 11. The foundation layer 2 is disposed, and thus the first n-side semiconductor layer 11 with high crystallinity can be formed on the upper surface of the foundation layer 2. AlGaN or GaN may be used for the foundation layer 2, for example. A buffer layer may be further included between the foundation layer 2 and the substrate 1. The buffer layer is a layer for reducing a lattice mismatch between the substrate 1 and the foundation layer 2, and for example, undoped AlGaN or GaN may be used.

### First Semiconductor Portion 10

The first semiconductor portion 10 includes the first n-side semiconductor layer 11, the first active layer 12 disposed on the first n-side semiconductor layer 11 and configured to emit ultraviolet light, and the first p-side semiconductor layer 13 disposed on the first active layer 12 . The first semiconductor portion 10 is provided on the foundation layer 2.

### First n-side Semiconductor Layer 11

The first n-side semiconductor layer 11 includes at least one n-type semiconductor layer such as an n-side contact layer containing an n-type impurity. As the n-type impurity, for example, Si, Ge, or the like may be used. The thickness of the first n-side semiconductor layer 11 is in a range of 5 µm to 15 µm, for example. The first n-side semiconductor layer 11 may further include a superlattice layer and an undoped layer.

For example, the n-side electrode 3 described below is disposed on the exposed upper surface of the first n-side semiconductor layer 11 where a portion of the n-side contact layer is exposed. The n-side contact layer is preferably doped with an n-type impurity at a relatively high concentration. The n-type impurity concentration in the n-side contact layer may be in a range of, for example, 1 × 10¹⁹/cm³ to 1 × 10²⁰/cm³. The n-side contact layer may be formed of AlGaN, for example. The Al composition ratio is in a range of 1% to 20%, for example, and is appropriately set in consideration of the light emission wavelength of the first active layer 12. The thickness of the n-side contact layer is, for example, in a range of 1 µm to 5 µm.

### n-side Electrode 3

As the metal material of the n-side electrode 3, for example, Ti, Rh, Au, Pt, Al, Ag, or Ru can be used.

### First Active Layer 12

The first active layer 12, for example, may be formed using a single quantum well structure or a multi-quantum well structure including a well layer(s) and a barrier layer(s). In the multi-quantum well structure for example, as illustrated in FIG. 1, after a plurality of pairs of the first barrier layer 121 and the first well layer 122 are layered, the first barrier layer 123 can be formed at the position closest to the first p-side semiconductor layer 13 in the first active layer 12.

The first well layer 122 is formed of, for example, a nitride semiconductor containing Al. The first well layer 122 that emits ultraviolet light having a wavelength around 380 nm may be formed of GaN or GaN containing a slight amount of In. Here, the term "slight amount" means, for example, a range of 0.1% to 0.5%. The first well layer 122 can be formed of, for example, a nitride semiconductor containing GaN as a main component with an In composition ratio of about 0.3%. The first well layer 122 that emits ultraviolet light with a short wavelength may be formed of, for example, an AlGaN layer, and ultraviolet light having a desired short wavelength can be emitted by adjusting the Al composition ratio.

The thickness of the first well layer 122 is in a range of 10 nm to 20 nm, for example.

The first barrier layers 121 and the first barrier layer 123 in the first active layer 12 are formed of, for example, AlGaN or the like having a wider band gap than the first well layers 122. The first barrier layers 121 and the first barrier layer 123 are provided on both sides of the first well layers 122. The band gap of one of the first barrier layers 121 and the band gap of the first barrier layer 123 may be the same or different from each other. Each of the first barrier layer 121 and the first barrier layer 123 may be formed of two or more layers. The first barrier layer 121 and the first barrier layer 123 may contain an n-type impurity. The first barrier layer 121 may be formed of a layer containing an n-type impurity, and the first barrier layer 123 may be formed of an undoped layer. With the first barrier layer 121 containing the n-type impurity, the forward voltage of the nitride semiconductor light-emitting element 100 can be reduced.

The thickness of the first barrier layer 121 and the thickness of the first barrier layer 123 are in a range of 10 nm to 50 nm, for example. The thickness of the first barrier layer 121 and the thickness of the first barrier layer 123 may be the same or different from each other, but it is preferable that the thickness of the first barrier layer 123 is greater than the thickness of the first barrier layer 121. By making the thickness of the first barrier layer 123 greater than the thickness of the first barrier layer 121, and thus it is possible to reduce a decrease in luminous efficiency due to diffusion of the p-type impurity of the first p-side semiconductor layer 13 into the first well layer 122. In a case where the thickness of the first barrier layer 123 is greater than the thickness of the first barrier layer 121, the thickness of the first barrier layer 123 is, for example, in a range of 110% to 200% of the thickness of the first barrier layer 121.

### First p-side Semiconductor Layer 13

The first p-side semiconductor layer 13 includes the fifth layer 135 provided on the first barrier layer 123, the first layer 131 provided on the fifth layer 135, and the second layer 132 provided on the first layer 131.

The fifth layer 135 is a layer having a wider band gap than the first barrier layer 123, the first layer 131 and the second layer 132, and may be formed of, for example, an AlGaN layer having a high Al composition ratio. As described above, the first p-side semiconductor layer 13 includes the fifth layer 135 having a wide band gap, and thus, it is possible to suppress the movement of electrons from the first active layer 12 to the second semiconductor portion 20, and to confine a necessary quantity of electrons in the first active layer 12. In a case where the fifth layer 135 is formed of, for example, an AlGaN layer, the Al composition ratio is, for example, in a range of 1% to 30%.

The first layer 131 is a layer containing Al. The Al composition ratio of the first layer 131 is lower than at least one of the Al composition ratio of the fifth layer 135 or the Al composition ratio of the second layer 132. The Al composition ratio of the first layer 131 is preferably lower than the Al composition ratio of the fifth layer 135 and the Al composition ratio of the second layer 132. The first layer 131 may be formed of an AlGaN layer. The Al composition ratio of the first layer 131 is in a range of 1% to 30% and preferably in a range of 4% to 10%. Reducing the Al composition ratio of the first layer 131 makes it possible to suppress an increase in the forward voltage.

Also, the p-type impurity concentration in the first layer 131 is preferably lower than the p-type impurity concentration in the fifth layer 135. The first layer 131 is preferably an undoped layer. Here, the term "an undoped layer" means a layer which is not intentionally doped with impurities. The p-type impurity concentration in the first layer 131 is set lower than the p-type impurity concentration in the fifth layer 135, so that the electrostatic breakdown voltage of the nitride semiconductor light-emitting element 100 can be improved. In addition, the first layer 131 is an undoped layer, so that the electrostatic breakdown voltage of the nitride semiconductor light-emitting element 100 can be further improved. The p-type impurity concentration in the first layer 131 may be lower than the p-type impurity concentration in the second layer 132.

The first layer 131 has the function of filling V-pits. Here, a V-pit is a recess-shaped pit formed in a semiconductor layer due to dislocation formed when the semiconductor layer is epitaxially grown. The V-pit is formed, for example, starting from the dislocation formed when the first active layer 12 is grown. A V-pit may be formed starting from a layer below the first active layer 12, and is formed extending through the first active layer 12. Here, the thickness of the first layer 131 is preferably large in order to fill the V-pits adequately and improve the electrostatic breakdown voltage. However, because the first layer 131 contains Al, there is a possibility that the forward voltage may increase if the first layer 131 is too thick. Thus, the thickness of the first layer 131 is set to be less than the thickness of the third layer 233. In this manner, the first layer 131 can fill the V-pits adequately, which can improve the electrostatic breakdown voltage and reduce an increase in the forward voltage. Preferably, the thickness of the first layer 131 is, for example, in a range of 10 nm to 300 nm and more preferably in a range of 20 nm to 100 nm.

The second layer 132 is a p-type semiconductor layer joined via a tunnel junction to the second n-side semiconductor layer 21. The second layer 132 joined via a tunnel junction to the second n-side semiconductor layer 21 contains a p-type impurity at a high concentration so as to form a tunnel junction. The p-type impurity concentration in the second layer 132 is higher than the p-type impurity concentration in the first layer 131 and the p-type impurity concentration in the fifth layer 135. Here, the p-type impurity is, for example, Mg. The p-type impurity concentration in the second layer 132 is, for example, in a range of 1 × 10¹⁹/cm³ to 3 × 10²¹/cm³ and preferably in a range of 1 × 10²⁰/cm³ to 1 × 10²¹/cm³.

### Second n-side Semiconductor Layer 21

The second n-side semiconductor layer 21 is a layer joined via a tunnel junction to the second layer 132 of the first semiconductor portion 10. The second n-side semiconductor layer 21 has the function of supplying electrons to the second active layer 22. The second n-side semiconductor layer 21 may be formed of a plurality of n-type semiconductor layers, and may include, for example, a layer containing an n-type impurity at a high concentration and joined via a tunnel junction to the second layer 132, and one or two or more n-type semiconductor layers containing an n-type impurity at a lower concentration than the layer described above. The n-type impurity concentration in the layer of the second n-side semiconductor layer 21, containing an n-type impurity at a high concentration and joined via a tunnel junction to the second layer 132 is, for example, in a range of 1 × 10¹⁹/cm³ to 3 × 10²¹/cm³ and preferably in a range of 1 × 10²⁰/cm³ to 2 × 10²¹/cm³.

The layer joined via a tunnel junction to the second layer 132 is, for example, a nitride semiconductor layer containing Al, and is, for example, an AlGaN layer. The n-type impurity doped into the n-type semiconductor layer of the second n-side semiconductor layer 21 is, for example, silicon (Si) or germanium (Ge).

### Second Active Layer 22

Similarly to the first active layer 12, the second active layer 22, for example, may be formed using a single quantum well structure or a multi-quantum well structure including a well layer(s) and a barrier layer(s). In the multi-quantum well structure for example, as illustrated in FIG. 1, after a plurality of pairs including the second barrier layer 221 and the second well layer 222 are layered, the second barrier layer 223 can be formed at the position closest to the second p-side semiconductor layer 23 in the second active layer 22. The light emission wavelength of the second active layer 22 may be the same as or different from the light emission wavelength of the first active layer 12.

The second active layer 22 may be configured identically or similarly to the first active layer 12, as described below.

The second well layer 222 is formed of, for example, a nitride semiconductor containing Al. The second well layer 222 that emits ultraviolet light having a wavelength around 380 nm may be formed of GaN or GaN containing a slight amount of In. Here, the term "slight amount" means, for example, a range of 0.1% to 0.5%. The second well layer 222 can be formed of, for example, a nitride semiconductor containing GaN as a main component with an In composition ratio of about 0.3%. The second well layer 222 that emits ultraviolet light with a short wavelength may be formed of, for example, an AlGaN layer, and ultraviolet light having a desired short wavelength can be emitted by adjusting the Al composition ratio.

The thickness of the second well layer 222 is in a range of 10 nm to 20 nm, for example.

The second barrier layers 221 and the second barrier layer 223 in the second active layer 22 are formed of, for example, AlGaN or the like having a wider band gap than the second well layers 222. The second barrier layers 221 and the second barrier layer 223 are provided on both sides of the second well layers 222. The band gap of one of the second barrier layers 221 and the band gap of the second barrier layer 223 may be the same or different from each other. Each of the second barrier layer 221 and the second barrier layer 223 may be formed of two or more layers. The second barrier layer 221 and the second barrier layer 223 may contain an n-type impurity. The second barrier layer 221 may be formed of a layer containing an n-type impurity, and the second barrier layer 223 may be formed of an undoped layer. Allowing the second barrier layer 221 to contain the n-type impurity can reduce the forward voltage of the nitride semiconductor light-emitting element 100.

The thickness of the second barrier layer 221 and the thickness of the second barrier layer 223 are in a range of 10 nm to 50 nm, for example. The thickness of the second barrier layer 221 and the thickness of the second barrier layer 223 may be the same or different from each other, but it is preferable that the thickness of the second barrier layer 221 is greater than the thickness of the second barrier layer 223. The thickness of the second barrier layer 223 is greater than the thickness of the second barrier layer 221, and thus it is possible to reduce a decrease in luminous efficiency due to diffusion of the p-type impurity of the second p-side semiconductor layer 23 into the second well layer 222. In a case where the thickness of the second barrier layer 223 is greater than the thickness of the second barrier layer 221, the thickness of the second barrier layer 223 is, for example, in a range of 110% to 200% of the thickness of the second barrier layer 221.

### Second p-side Semiconductor Layer 23

The second p-side semiconductor layer 23 includes the sixth layer 236 provided on the second barrier layer 223, the third layer 233 provided on the sixth layer 236, and the fourth layer 234 provided on the third layer 233.

The sixth layer 236 is a layer having a wider band gap than the second barrier layer 223, the third layer 233, and the fourth layer 234, and may be formed of, for example, an AlGaN layer having a high Al composition ratio. The second p-side semiconductor layer 23 includes the sixth layer 236 having a wide band gap, and thus, it is possible to suppress the movement of electrons from the second active layer 22, and to confine the electrons in the second active layer 22. In a case where the sixth layer 236 is formed of, for example, an AlGaN layer, the Al composition ratio is, for example, in a range of 1% to 30% and preferably in a range of 20% to 30%.

The third layer 233 is a layer containing Al. The Al composition ratio of the third layer 233 is lower than at least one of the Al composition ratio of the sixth layer 236 or the Al composition ratio of the fourth layer 234. The Al composition ratio of the third layer 233 is preferably lower than the Al composition ratio of the sixth layer 236 and the Al composition ratio of the fourth layer 234. The third layer 233 may be formed of an AlGaN layer. The Al composition ratio of the third layer 233 is, for example, in a range of 1% to 30% and preferably in a range of 2% to 10%. Reducing the Al composition ratio of the third layer 233 makes it possible to suppress an increase in the forward voltage. The p-type impurity concentration in the third layer 233 is preferably lower than the p-type impurity concentration in the sixth layer 236 and the fourth layer 234. The third layer 233 is preferably an undoped layer. Here, the term "an undoped layer" means a layer which is not intentionally doped with impurities. The p-type impurity concentration of the third layer 233 is set lower than the p-type impurity concentration in the sixth layer 236 and the fourth layer 234, so that the electrostatic breakdown voltage of the nitride semiconductor light-emitting element 100 can be improved. In addition, the third layer 233 is an undoped layer, so that the electrostatic breakdown voltage of the nitride semiconductor light-emitting element 100 can be further improved.

The third layer 233 has the function of filling V-pits. Here, as described above, a V-pit is a recess-shaped pit formed in a semiconductor layer due to dislocation formed when the semiconductor layer is epitaxially grown. As described above, the V-pits that are formed, starting from the dislocations formed when the first active layer 12 is grown, or the V-pits that are formed starting from the layer below the first active layer 12 and extend through the first active layer 12 are filled to some extent by the first layer 131. However, when the layers above the first active layer 12, for example, the first p-side semiconductor layer 13, the second n-side semiconductor layer 21, and the second active layer 22 are grown, V-pits are additionally generated, starting from the remaining V-pits formed in the layer below the first active layer 12. The third layer 233 is formed thicker than the first layer 131, and thus the V-pits including the remaining V-pits can be filled adequately.

In consideration of adequately filling the V-pits including the remaining V-pits, a preferable thickness of the third layer 233 is, for example, in a range of 50 nm to 400 nm. In this manner, the third layer 233 can fill the V-pits adequately, which can improve the electrostatic breakdown voltage.

The fourth layer 234 is a p-type semiconductor layer where the p-side electrode 4 is formed. The fourth layer 234 contains a p-type impurity at a relatively high concentration so as to reduce the contact resistance with the p-side electrode 4 and contains a p-type impurity at a concentration higher than at least the third layer 233. Here, the p-type impurity is, for example, Mg. The p-type impurity concentration in the fourth layer 234 is in a range of 1 x 10¹⁹/cm³ to 1 x 10²¹/cm³, for example. The thickness of the fourth layer 234 is in a range of 1 nm to 30 nm, for example.

### p-side Electrode 4

The p-side electrode 4 is provided on the second p-side semiconductor layer 23 and is in contact with the fourth layer 234 containing Al and a p-type impurity. The p-side electrode 4, for example, can include a light-transmissive conductive layer 41 formed of indium tin oxide (ITO), indium zinc oxide (IZO), ZnO, or In₂O₃, and a pad electrode 42. The light-transmissive conductive layer 41 is provided in contact with the fourth layer 234, and the pad electrode 42 is provided on the light-transmissive conductive layer 41. As the metal material of the pad electrode 42, for example, Ti, Rh, Au, Pt, Al, Ag, or Ru can be used.

The nitride semiconductor light-emitting element 100 according to the embodiment described above can provide a nitride semiconductor light-emitting element that emits ultraviolet light with a low forward voltage.

### Examples and Comparative Examples

Examples and Comparative Example will be described below.

Nitride semiconductor light-emitting elements according to Examples 1 to 4 and Comparative Examples 1 to 3 described below were prepared, and their respective forward voltages were measured.

Here, the nitride semiconductor light-emitting elements according to Examples 1 to 4 and Comparative Examples 1 to 3 have the layer structure illustrated in FIG. 1, and are identical except for the thicknesses of the first layer 131 and the third layer 233.

Thus, first, common layers, except for the thicknesses of the first layer 131 and the third layer 233, in the nitride semiconductor light-emitting elements according to Examples 1 to 4 and Comparative Examples 1 to 3 will be described in detail, and then, measurement results of the thicknesses of the first layer 131 and the third layer 233 and the forward voltages in the nitride semiconductor light-emitting elements according to Examples 1 to 4 and Comparative Examples 1 to 3 will be described.

### 1. Substrate 1

The substrate 1 is a sapphire substrate having an upper surface on which a nitride semiconductor layer is grown. The upper surface is defined as a C plane.

### 2. Foundation Layer 2

An undoped GaN layer was grown on the C plane of the sapphire substrate 1 to a thickness of 6500 nm to form the foundation layer 2.

### 3. First n-side Semiconductor Layer 11

On the foundation layer 2, an Al_{0.05} Ga_{0.95} N layer doped with Si and having an Al composition ratio of 5% was grown to a thickness of 3000 nm, and a superlattice layer alternately including AlGaN layers having different Al composition ratios was grown on the Al_{0.05} Ga_{0.95} N layer to form the first n-side semiconductor layer 11.

The superlattice layer was formed by growing a pair of layers, including an Al_{0.095} Ga_{0.905} N layer doped with Si and having an Al composition ratio of 9.5%, and an undoped Al_{0.04} Ga_{0.96} N layer with an Al composition ratio of 4%, repeatedly in three cycles. In each of the cycles, the Al_{0.095} Ga_{0.905} N layer was grown to 29 nm and then the undoped Al_{0.04} Ga_{0.96} N layer was grown to 5 nm.

### 4. First Active Layer 12

A pair of the first barrier layer 121 and the first well layer 122 was formed repeatedly in two cycles. In each of the cycles, the first barrier layer 121 was formed by growing an Al_{0.095} Ga_{0.905} N layer doped with Si and having an Al composition ratio of 9.5% to 29 nm on the superlattice layer of the first n-side semiconductor layer 11, and then the first well layer 122 was formed by growing an undoped In_{0.003} Ga_{0.997} N layer having an In composition ratio of 0.3% to 15 nm on the first barrier layer 121. Thereafter, an undoped Al_{0.095} Ga_{0.905} N layer having an Al composition ratio of 9.5% was grown to 40 nm to form the first barrier layer 123 and thereby form the first active layer 12.

### 5. First p-side Semiconductor Layer 13

On the first barrier layer 123 of the first active layer 12,
(a) the fifth layer 135 was formed by growing an Al_{0.25} Ga_{0.75} N layer doped with Mg and having an Al composition ratio of 25% to a thickness of 22.5 nm;
(b) the first layer 131 was formed by growing an undoped Al_{0.065} Ga_{0.935} N layer having an Al composition ratio of 6.5% on the fifth layer 135 to a thickness of t1 nm; and
(c) the second layer 132 was formed by growing an Al_{0.085} Ga_{0.915} N layer doped with Mg and having an Al composition ratio of 8.5% on the first layer 131 to 18.5 nm, thereby forming the first p-side semiconductor layer 13.

The Mg doping amount in the second layer 132 was set to 1 × 10²⁰/cm³ so as to form a tunnel junction with the second n-side semiconductor layer 21.

### 6. Second n-side Semiconductor Layer 21

On the first p-side semiconductor layer 13,
(a) an Al_{0.095} Ga_{0.905} N layer doped with Si and having an Al composition ratio of 9.5% was grown to a thickness of 47.5 nm;
(b) an Al_{0.065} Ga_{0.935} N layer doped with Si and having an Al composition ratio of 6.5% was grown on the Al_{0.095} Ga_{0.905} N layer to a thickness of a 80 nm; and
(c) a superlattice layer alternately including AlGaN layers having different Al composition ratios was grown on the Al_{0.065} Ga_{0.935} N layer, thereby forming the second n-side semiconductor layer 21.

The superlattice layer was formed by growing a pair of layers, including an Al_{0.095} Ga_{0.905} N layer doped with Si and having an Al composition ratio of 9.5%, and an undoped Al_{0.04} Ga_{0.96} N layer with an Al composition ratio of 4%, repeatedly in three cycles. In each of the cycles, the Al_{0.095} Ga_{0.905} N layer was grown to 29 nm and then the undoped Al_{0.04} Ga_{0.96} N layer was grown to 5 nm.

The Si doping amount in the Al_{0.095} Ga_{0.905} N layer having an Al composition ratio of 9.5% was set to 1 × 10²¹/cm³ so as to form a tunnel junction with the first p-side semiconductor layer 13.

### 7. Second Active Layer 22

A pair of the second barrier layer 221 and the second well layer 222 was formed repeatedly in two cycles. In each of the cycles, the second barrier layer 221 was formed by growing an Al_{0.095} Ga_{0.905} N layer doped with Si and having an Al composition ratio of 9.5% to 29 nm on the superlattice layer of the second n-side semiconductor layer 21, and then the second well layer 222 was formed by growing an undoped In_{0.003} Ga_{0.997} N layer having an In composition ratio of 0.3% to 15 nm on the second barrier layer 221. Thereafter, an undoped Al_{0.095} Ga_{0.905} N layer having an Al composition ratio of 9.5% was grown to 40 nm to form the second barrier layer 223. In this manner, the second active layer 22 was formed.

### 8. Second p-side Semiconductor Layer 23

On the second barrier layer 223 of the second active layer 22,
(a) the sixth layer 236 was formed by growing an Al_{0.25} Ga_{0.75} N layer doped with Mg and having an Al composition ratio of 25% to a thickness of 22.5 nm;
(b) the third layer 233 was formed by growing an undoped Al_{0.065} Ga_{0.935} N layer having an Al composition ratio of 6.5% on the sixth layer 236 to a thickness of t2 nm; and
(c) the fourth layer 234 was formed by growing an Al_{0.085} Ga_{0.915} N layer doped with Mg and having an Al composition ratio of 8.5% on the third layer 233 to 12 nm, thereby forming the second p-side semiconductor layer 23.

After forming the layers as described above, the n-side electrode 3 located below the superlattice layer of the first n-side semiconductor layer 11 was formed by exposing a part of the Al_{0.05} Ga_{0.95} N layer doped with Si, having an Al composition ratio of 5%. The p-side electrode 4 was formed on the fourth layer 234 of the second p-side semiconductor layer 23.

The n-side electrode 3 had a layered structure of Ti/ Pt/Au/Pt/Ti from the first n-side semiconductor layer 11 side. The pad electrode 42 of the p-side electrode 4 had a layered structure of Ti/Pt/Au from the second p-side semiconductor layer 23 side. In each of Examples and Comparative Examples, the light-transmissive conductive layer 41 was not used.

In the nitride semiconductor light-emitting elements according to Examples 1 to 4 and Comparative Examples 1 to 3, the first layer 131 and the third layer 233 were formed to have the thicknesses illustrated in Table 1.

**[Table 1]**

| | Thickness t1 of first layer 131 | Thickness t2 of third layer 233 |
|---|---|---|
| Example 1 | 90 nm | 150 nm |
| Example 2 | 70 nm | 150 nm |
| Example 3 | 50 nm | 150 nm |
| Example 4 | 30 nm | 150 nm |
| Comparative Example 1 | 110 nm | 110 nm |
| Comparative Example 2 | 110 nm | 90 nm |
| Comparative Example 3 | 110 nm | 70 nm |

The measurement results of forward voltage for the nitride semiconductor light-emitting elements according to Examples 1 to 4 and Comparative Examples 1 to 3 are illustrated in Table 2.

**[Table 2]**

| | Forward voltage |
|---|---|
| Example 1 | 10.78 (V) |
| Example 2 | 9.87 (V) |
| Example 3 | 9.28 (V) |
| Example 4 | 8.71 (V) |
| Comparative Example 1 | 11.28 (V) |
| Comparative Example 2 | 11.19 (V) |
| Comparative Example 3 | 11.21 (V) |

As illustrated in Tables 1 and 2, it was confirmed that in Examples 1 to 4 in which the thickness t1 of the first layer 131 was less than the thickness t2 of the third layer 233, the forward voltage could be lower than in Comparative Examples 1 to 3 in which the thickness t1 of the first layer 131 was equal to or greater than the thickness t2 of the third layer 233.

Embodiments of the present invention encompasses the following aspects.

[Aspect 1] A nitride semiconductor light-emitting element comprising:
a first semiconductor portion comprising:
   a first n-side semiconductor layer,
   a first active layer disposed on the first n-side semiconductor layer and configured to emit ultraviolet light, and
   a first p-side semiconductor layer disposed on the first active layer; and
a second semiconductor portion comprising:
   a second n-side semiconductor layer disposed on the first semiconductor portion,
   a second active layer disposed on the second n-side semiconductor layer and configured to emit ultraviolet light, and
   a second p-side semiconductor layer disposed on the second active layer;
wherein:
the first p-side semiconductor layer comprises:
   a first layer containing Al, and
   a second layer disposed on the first layer and containing Al and a p-type impurity;
the second p-side semiconductor layer comprises:
   a third layer containing Al, and
   a fourth layer disposed on the third layer and containing Al and a p-type impurity;
the second n-side semiconductor layer is joined via a tunnel junction to the second layer; and
a thickness of the first layer is less than a thickness of the third layer.

[Aspect 2] The nitride semiconductor light-emitting element according to Aspect 1, wherein an Al composition ratio of the first layer is lower than an Al composition ratio of the third layer.

[Aspect 3] The nitride semiconductor light-emitting element according to Aspect 1 or 2, wherein:
the thickness of the first layer is in a range of 20 nm to 120 nm; and
the thickness of the third layer is in a range of 130 nm to 180 nm.

[Aspect 4] The nitride semiconductor light-emitting element according to any one of Aspects 1 to 3, wherein:
the first active layer comprises:
   a first well layer, and
   a first barrier layer containing Al; and
the Al composition ratio of the first layer is lower than an Al composition ratio of the first barrier layer.

[Aspect 5] The nitride semiconductor light-emitting element according to any one of Aspects 1 to 4, wherein:
the second active layer comprises:
   a second well layer, and
   a second barrier layer containing Al: and
the Al composition ratio of the third layer is lower than an Al composition ratio of the second barrier layer.

[Aspect 6] The nitride semiconductor light-emitting element according to any one of Aspects 1 to 5, wherein:
the first p-side semiconductor layer comprises a fifth layer containing Al and located between the first layer and the first active layer;
the second p-side semiconductor layer comprises a sixth layer containing Al between the third layer and the second active layer; and
a thickness of the fifth layer is less than a thickness of the sixth layer and/or an Al composition ratio of the fifth layer is lower than an Al composition ratio of the sixth layer.

[Aspect 7] The nitride semiconductor light-emitting element according to Aspect 6, wherein the thickness of the first layer is greater than the thickness of the fifth layer.

[Aspect 8] The nitride semiconductor light-emitting element according to Aspect 6 or 7, wherein:
the fifth layer and the sixth layer are doped with a p-type impurity; and
a p-type impurity concentration in the fifth layer is higher than a p-type impurity concentration in the sixth layer.

### Reference Signs List

100 Nitride semiconductor light-emitting element
1 Substrate
2 Foundation layer
10 First semiconductor portion
11 First n-side semiconductor layer
12 First active layer
122 First well layer
121, 123 First barrier layer
13 First p-side semiconductor layer
131 First layer
132 Second layer
135 Fifth layer
20 Second semiconductor portion
21 Second n-side semiconductor layer
22 Second active layer
222 Second well layer
221, 223 Second barrier layer
23 Second p-side semiconductor layer
233 Third layer
234 Fourth layer
236 Sixth layer

## Claims

1. A nitride semiconductor light-emitting element comprising:
a first semiconductor portion comprising:
a first n-side semiconductor layer,
a first active layer disposed on the first n-side semiconductor layer and configured to emit ultraviolet light, and
a first p-side semiconductor layer disposed on the first active layer; and
a second semiconductor portion comprising:
a second n-side semiconductor layer disposed on the first semiconductor portion,
a second active layer disposed on the second n-side semiconductor layer and configured to emit ultraviolet light, and
a second p-side semiconductor layer disposed on the second active layer;
wherein:
the first p-side semiconductor layer comprises:
a first layer containing Al, and
a second layer disposed on the first layer and containing Al and a p-type impurity;
the second p-side semiconductor layer comprises:
a third layer containing Al, and
a fourth layer disposed on the third layer and containing Al and a p-type impurity;
the second n-side semiconductor layer is joined via a tunnel junction to the second layer; and
a thickness of the first layer is less than a thickness of the third layer.

2. The nitride semiconductor light-emitting element according to claim 1, wherein an Al composition ratio of the first layer is lower than an Al composition ratio of the third layer.

3. The nitride semiconductor light-emitting element according to claim 1 or 2, wherein:
the thickness of the first layer is in a range of 20 nm to 120 nm; and
the thickness of the third layer is in a range of 130 nm to 180 nm.

4. The nitride semiconductor light-emitting element according to any one of claims 1 to 3, wherein:
the first active layer comprises:
a first well layer, and
a first barrier layer containing Al; and
the Al composition ratio of the first layer is lower than an Al composition ratio of the first barrier layer.

5. The nitride semiconductor light-emitting element according to any one of claims 1 to 4, wherein:
the second active layer comprises:
a second well layer, and
a second barrier layer containing Al: and
the Al composition ratio of the third layer is lower than an Al composition ratio of the second barrier layer.

6. The nitride semiconductor light-emitting element according to any one of claims 1 to 5, wherein:
the first p-side semiconductor layer comprises a fifth layer containing Al and located between the first layer and the first active layer;
the second p-side semiconductor layer comprises a sixth layer containing Al between the third layer and the second active layer; and
a thickness of the fifth layer is less than a thickness of the sixth layer and/or an Al composition ratio of the fifth layer is lower than an Al composition ratio of the sixth layer.

7. The nitride semiconductor light-emitting element according to claim 6, wherein the thickness of the first layer is greater than the thickness of the fifth layer.

8. The nitride semiconductor light-emitting element according to claim 6 or 7, wherein:
the fifth layer and the sixth layer are doped with a p-type impurity; and
a p-type impurity concentration in the fifth layer is higher than a p-type impurity concentration in the sixth layer.
